# EUROPEAN PATENT SPECIFICATION

(11) **EP 2 054 233 B1**
(45) Date of publication and mention of the grant of the patent: **29.09.2010**
(21) Application number: 07811203.4
(22) Date of filing: 08.08.2007
(51) Int. Cl.: B41M 3/00, B41F 17/00, H01L 51/00

(54) **METHOD TO FORM A PATTERN OF FUNCTIONAL MATERIAL ON A SUBSTRATE**
VERFAHREN ZUR FORMUNG EINES MUSTERS AUS EINEM FUNKTIONSMATERIAL AUF EINEM SUBSTRAT
PROCÉDÉ DE FORMATION D'UN MOTIF DE MATÉRIAU FONCTIONNEL SUR UN SUSTRAT

(30) Priority: 23.08.2006 US 508806
(43) Date of publication of application: 06.05.2009
(73) Proprietor: E.I. DU PONT DE NEMOURS AND COMPANY, Wilmington, DE 19898 (US)
(72) Inventor: BLANCHET, Graciela, Beatriz, Greenville, Delaware 19807 (US); LEE, Hee Hyun, Greenville, Delaware 19807 (US)
(74) Representative: Towler, Philip Dean
(86) International application number: PCT/US2007/017670
(87) International publication number: WO 2008/024207

(56) References cited:
- WO-A-03/031136
- WO-A-2006/047215

## Description

### BACKGROUND OF THE INVENTION

### 1. Field of the Invention

This invention pertains to a method for forming a pattern of functional material on a substrate, and in particular, the method uses an elastomeric stamp having a relief surface to form a pattern of open area on the substrate where the functional material is applied.

### 2. Description of Related Art

Nearly all electronic and optical devices require patterning. Microelectronic devices have long been prepared by photolithographic processes to form the necessary patterns. According to this technique a thin film of conducting, insulating, or semiconducting material is deposited on a substrate and a negative or positive photoresist is coated onto the exposed surface of the material. The resist is then irradiated in a predetermined pattern, and irradiated or non-irradiated portions of the resist are washed from the surface to produce a predetermined pattern of resist on the surface. To form a pattern of a conducting metal material, the metal material that is not covered by the predetermined resist pattern is then etched or removed. The resist pattern is then removed to obtain the pattern of metal material. Photolithography, however, is a complex, multi-step process that is too costly for the printing of plastic electronics.

Microcontact printing is a flexible, non-lithographic method for forming patterned materials. Microcontact printing potentially provides a significant advance over conventional photolithographic techniques since the contact printing can form relatively high resolution patterns on plastic electronics for electronic parts assembly. Microcontact printing can be characterized as a high resolution technique that enables patterns of micrometer dimensions to be imparted onto a substrate surface. Microcontact printing is also more economical than photolithography systems since it is procedurally less complex, not requiring spin coating equipment or a clean room environment. In addition, microcontact printing potentially lends itself to reel-to-reel electronic parts assembly operations that allows for high throughput production than other techniques, such as photolithography and e-beam lithography (which is a conventional technique employed where resolution on the order of 10s of nanometer is desired). Multiple images can be printed from a single stamp in reel-to-reel assembly operations using microcontact printing.

Microcontact printing technique is a possible replacement to photolithography in the fabrication of microelectronic devices, such as radio frequency tags (RFID), sensors, and memory and backpanel displays. The capability of microcontact printing to transfer self-assembled monolayers (SAM) forming molecular species to a substrate has also found application in patterned electroless deposition of metals. SAM printing is capable of creating high resolution patterns, but is generally limited to forming metal patterns of gold or silver with thiol chemistry. Although there are variations, in SAM printing a positive relief pattern provided on an elastomeric stamp is inked onto a substrate. The relief pattern of the elastomeric stamp, which is typically made of polydimethylsiloxane (PDMS), is inked with a thiol material. Typically the thiol material is an alkane thiol material. The substrate is blanket coated with a thin metal film of gold or silver, and then the gold-coated substrate is contacted with the stamp. Upon contact of the relief pattern of the stamp with the metal film, a monolayer of the thiol material having the desired microcircuit pattern is transferred to the metal film. Alkane thiols form an ordered monolayer on metal by a self-assembly process, which results in the SAM being tightly packed and well adhered to the metal. As such, the SAM acts as an etch resist when the inked substrate is then immersed in a metal etching solution and all but the SAM protected metal areas are etched away to the underlying substrate. The SAM is then stripped away leaving the metal in the desired pattern.

A method of transferring a material to a substrate, particularly for light emitting devices, is disclosed by Coe-Sullivan et al. in WO 2006/047215. The method includes selectively depositing the material on a surface of a stamp applicator and contacting the surface of the stamp applicator to the substrate. The stamp applicator may be textured, that is have a surface with a pattern of elevations and depressions, or may be featureless, that is, having no elevations or depressions. The material is a nanomaterial ink, which includes semiconductor nanocrystals. Direct contact printing of the material on the substrate eliminates the steps associated with printing of SAM in which excess material that does not form the desired microcircuitry pattern from the substrate is etched away or removed.

Direct microcontact printing of SAM of thiol materials or other materials such as those described in WO 2006/047215 may be achievable in microelectronic devices and components having a high density of features. However, microcontact printing of devices and components having the pattern of fine resolution lines of functional material separated by relatively large featureless areas where no functional material resides can be problematic. The stamp can sag in areas between features where the density of features is low or the separation of between features is large. Sagging of the relief surface of the stamp is a phenomenon in which a lowermost surface of recessed areas of the relief structure collapse or sag toward an uppermost surface of the raise areas. Sagging may also be called roof collapse of the stamp. Sagging of the relief surface can cause the recessed areas to print material where there should be no material. The recessed areas sag into contact sufficient to transfer material onto the substrate in undesired regions that are not a part of the pattern of lines being formed. Sagging of the recessed areas of the stamp can even be exacerbated when pressure is applied to the stamp. Pressure on the stamp is sometimes necessary in order to achieve transfer of the material pattern to the substrate. If the material transferred is large, it may contact one or more of the pattern lines of the functional material, which can destroy the use of the component. Microcontact printing of conductive patterns, particularly using SAM layers, where the sagging of the stamp transfers material onto background areas can lead to shorting the devices or components.

In addition to the feature density pattern incorporated in the stamp, the elastic nature of stamp may contribute to sagging in featureless areas. The stamp used for microcontact printing is elastomeric in order for the stamp to sufficiently contact the substrate while conforming to various surfaces including on cylindrical or spherical surfaces, or discontinuous or multiplanar surfaces. However the features of the stamp may have an aspect ratio (determined by the width of features divided by height of features on the stamp) such that sagging is caused in the recessed areas between the pattern of fine resolution line features.

So it is desirable to provide a method for forming a pattern of a functional material, such as a conductor, semiconductor, or dielectric material, onto a substrate. It is also desirable for such method to have the ease of microcontact printing with an elastomeric stamp, but not be limited to printing onto metals. It is also desirable for such a method to avoid the problem of transfer of the functional material in featureless areas of the pattern.

### SUMMARY OF THE INVENTION

The present invention provides a method to form a pattern of functional material on a substrate. The method includes providing an elastomeric stamp having a raised surface in a relief structure with a mask material on at least the raised surface of the relief structure; transferring the mask material from the raised surface to the substrate to form a pattern of open area on the substrate; and applying the functional material to the open area on the substrate forming the pattern.

### BRIEF DESCRIPTION OF THE DRAWINGS

Figure 1 is a sectional elevation view of a master having a relief structure that forms a pattern of a microcircuit or other functional electronic pathway.
Figure 2 is a sectional elevation view of one embodiment of a printing form precursor having a layer of an elastomeric material between a support and the master, the elastomeric layer being exposed to actinic radiation.
Figure 3 is a sectional elevation view of a stamp formed from the printing form precursor separating from the master. The stamp has a relief structure corresponding to the relief pattern of the master, and in particular, the relief structure of the stamp includes a pattern of at least a raised surface and a recessed surface that is the opposite of the relief pattern of the master.
Figure 4 is a sectional elevation view of the elastomeric stamp residing on a platform of a spin coater as one embodiment of applying a mask material to the relief structure of the stamp.
Figure 5 is a sectional elevation view of the elastomeric stamp having the layer of mask material on the raised surface of the relief structure contacting a substrate.
Figure 6 is a sectional elevation view of the elastomeric stamp separating from the substrate, and transferring the mask material on the raised surface to the substrate to form a pattern of mask material.
Figure 7 is a sectional elevation view of the substrate with the pattern of mask material on a platform of a spin coater as one embodiment of applying a functional material to open areas on the substrate that are not covered by the pattern of mask material.
Figure 8 is a sectional elevation view of the substrate with the functional material in a bath showing one embodiment of removing of the mask material to form a pattern of the functional material on the substrate.
Figure 9 is a sectional elevation view of the substrate with the pattern of the functional material showing an embodiment of an optional step in which the functional material is further treated by heating.
Figure 10a is an image of an electronic pattern of source drain lines fabricated according to a procedure described in the Comparative Example.
Figure 10b is an image of an electronic pattern of source drain lines fabricated according to a procedure described in Example 2.

### DESCRIPTION OF THE PREFERRED EMBODIMENT(S)

Throughout the following detailed description, similar reference characters refer to similar elements in all figures of the drawings.

The present invention provides a method to form a pattern of a functional material on a substrate for use in electronic applications. The method is applicable to the pattern formation of a variety of electronic materials, including conductors, semiconductors, and dielectrics, as the functional material. The method is not limited to the application by elastomeric stamps of thiol materials as a mask material. The method is capable of forming the pattern of the functional material onto a variety of substrates over large areas typically with at least 1 to 5 µm line resolution, and thus is particularly capable of forming microcircuitry. The method employs the ease of printing with an elastomeric stamp having a relief structure to transfer a mask material, without sagging or substantial sagging of the stamp and undesired transfer of material to the substrate. The method provides clean, open featureless background area between the lines of functional material, while retaining image fidelity and resolution associated with conventional microcontact printing. The method can be adapted to high-speed production processes for the fabrication of electronic devices and components, such as reel-to-reel processes.

A stamp is provided for patterning a substrate. The stamp includes a relief structure with a raised surface. Typically the relief structure will include a plurality of raised surfaces and a plurality of recessed surfaces. The relief structure of the stamp forms a pattern of raised surfaces for printing a mask material on a substrate. The pattern of the mask material on the substrate is the opposite or the negative of a pattern of the functional material desired for the electronic component or device. That is, the recessed surfaces of the relief structure of the elastomeric stamp represent the pattern of the function material that will ultimately be formed on the substrate by the present method, and the raised surfaces represent the background or featureless areas on the substrate. In one embodiment, the present method primarily avoids the problem of stamp sagging (i.e., roof collapse in the recessed portions) associated with standard microcontact printing due to the structure of the relief surface of the stamp. The raised surfaces of the stamp structure are relatively wide compared to the width of the recessed surfaces. Due to the relatively narrow dimension width of the recessed surfaces, elastomeric stamps formed and used by the present invention do not sag or substantially sag in the recessed surfaces and undesirably transfer material. The stamp prints from the raised surface/s the relatively wide lines of the mask material that will represent open background area on the electronic part ultimately formed. In one embodiment, the relief structure of the stamp will have raised surfaces that have widths greater than widths of the recessed surfaces. Although the above described embodiment of the relief structure of the stamp provides particular benefit, the present method is not limited to only embodiments where the raised surface/s has a width greater than the width of the recess surface/s. The present method is applicable to forming patterns of functional material regardless of the relative dimensions of the raised surfaces and the recessed surfaces of the stamp.

The stamp may be formed in conventional fashion as understood by those skilled in the art of microcontact printing. For example, a stamp may be fabricated by molding and curing a layer of a material on a master having a surface presenting a relief form (that is in opposite of the stamp relief structure). The stamp may be cured by exposure to actinic radiation, heating, or combinations thereof. The stamp thus includes a layer of the elastomeric material, which may be referred to as an elastomeric layer, cured layer, or cured elastomeric layer. The stamp may also, for example, be fabricated by ablating or engraving a material in a manner that generates the relief structure. The relief structure of the stamp is such that the raised surface has a height from the recessed surface sufficient for selective contact of the raised surface with a substrate. In one embodiment, the raised surface has a height from the recessed surface of about 0.2 to 20 µm. In another embodiment, the raised surface has a height from the recessed surface of about 0.2 to 2 µm. The stamp may be fabricated from any material that is capable of reproducing by relief printing a pattern of material on a substrate. The material of the stamp is elastomeric in order for at least a raised portion of the stamp to conform to a surface of the substrate so as to promote the complete transfer of the mask material thereto. Polymeric materials are suitable for forming the elastomeric stamp and are not limited to include, for example, silicone polymers, such as polydimethylsiloxane (PDMS); epoxy polymers, polymers of conjugated diolefin hydrocarbons, including polyisoprene, 1,2-polybutadiene, 1,4-polybutadiene, and butadiene/acrylonitrile; elastomeric block copolymers of an A-B-A type block copolymer, where A represents a non-elastomeric block, preferably a vinyl polymer and most preferably polystyrene, and B represents an elastomeric block, preferably polybutadiene or polyisoprene; acrylate polymers; and fluoropolymers. Examples of A-B-A block copolymers include but is not limited to poly(styrene-butadiene-styrene) and poly(styrene-isoprene-styrene). The polymeric material may be elastomeric or may become elastomeric upon curing.

In one embodiment, the material forming the elastomeric stamp is photosensitive such that the relief structure can be formed upon exposure to actinic radiation. The term "photosensitive" encompasses any system in which the photosensitive composition is capable of initiating a reaction or reactions, particularly photochemical reactions, upon response to actinic radiation. Upon exposure to actinic radiation, chain propagated polymerization of a monomer and/or oligomer is induced by either a condensation mechanism or by free radical addition polymerization. While all photopolymerizable mechanisms are contemplated, photosensitive compositions useful as elastomeric stamp material will be described in the context of free-radical initiated addition polymerization of monomers and/or oligomers having one or more terminal ethylenically unsaturated groups. In this context, the photoinitiator system when exposed to actinic radiation can act as a source of free radicals needed to initiate polymerization of the monomer and/or oligomer.

The composition is photosensitive since the composition contains a compound having at least one ethylenically unsaturated group capable of forming a polymer by photoinitiated addition polymerization. The photosensitive composition may also contain an initiating system activated by actinic radiation to induce photopolymerization. The polymerizable compound may have non-terminal ethylenically unsaturated groups, and/or the composition may contain one or more other components, such as a monomer, that promote crosslinking. As such, the term "photopolymerizable" is intended to encompass systems that are photopolymerizable, photocrosslinkable, or both. As used herein, photopolymerization may also be referred to as curing. The photosensitive composition forming the elastomeric stamp may include one or more constituents and/or additives, and can include, but is not limited to photoinitiators, one or more ethylenically unsaturated compounds (which may be referred to as monomers), fillers, surfactants, thermal polymerization inhibitors, processing aids, antioxidants, photosensitizers, and the like to stabilize or otherwise enhance the composition.

The photoinitiator can be any single compound or combination of compounds, which is sensitive to actinic radiation, generating free radicals which initiate the polymerization without excessive termination. Any of the known classes of photoinitiators, particularly free radical photoinitiators such as aromatic ketones, quinones, benzophenones, benzoin ethers, aryl ketones, peroxides, biimidazoles, benzyl dimethyl ketal, hydroxyl alkyl phenyl acetophone, dialkoxy actophenone, trimethylbenzoyl phosphine oxide derivatives, aminoketones, benzoyl cyclohexanol, methyl thio phenyl morpholino ketones, morpholino phenyl amino ketones, alpha halogennoacetophenones, oxysulfonyl ketones, sulfonyl ketones, oxysulfonyl ketones, sulfonyl ketones, benzoyl oxime esters, thioxanthrones, camphorquinones, ketocouumarins, and Michler's ketone may be used. In one embodiment, the photoinitiator can include a fluorinated photoinitiator that is based on known fluorine-free photoinitiators of the aromatic ketone type. Alternatively, the photoinitiator may be a mixture of compounds, one of which provides the free radicals when caused to do so by a sensitizer activated by radiation. Liquid photoinitiators are particularly suitable since they disperse well in the composition. Preferably, the initiator is sensitive to ultraviolet radiation. Photoinitiators are generally present in amounts from 0.001 % to 10.0% based on the weight of the photosensitive composition.

Monomers that can be used in the composition activated by actinic radiation are well known in the art, and include, but are not limited to, addition-polymerization ethylenically unsaturated compounds. The addition polymerization compound may also be an oligomer, and can be a single or a mixture of oligomers. The composition can contain a single monomer or a combination of monomers. The monomer compound capable of addition polymerization can be present in an amount less than 5%, preferably less than 3%, by weight of the composition.

In one embodiment the elastomeric stamp is composed of a photosensitive composition that includes a fluorinated compound that polymerizes upon exposure to actinic radiation to form a fluorinated elastomeric-based material. Suitable elastomeric-based fluorinated compounds include, but are not limited to, perfluoropolyethers, fluoroolefins, fluorinated thermoplastic elastomers, fluorinated epoxy resins, fluorinated monomers and fluorinated oligomers that can be polymerized or crosslinked by a polymerization reaction. In one embodiment, the fluorinated compound has one or more terminal ethylenically unsaturated groups that react to polymerize and form the fluorinated elastomeric material. The elastomeric-based fluorinated compounds can be homopolymerized or copolymerized with polymers such as polyurethanes, polyacrylates, polyesters, polysiloxanes, polyamides, and others, to attain desired characteristics of the printing form precursor and/or the stamp suitable for its use. Exposure to the actinic radiation is sufficient to polymerize the fluorinated compound and render its use as a printing stamp, such that application of high pressure and/or elevated temperatures above room temperature is not necessary. An advantage of compositions containing fluorinated compounds that cure by exposure to actinic radiation is that the composition cures relatively quickly (e.g., in a minutes or less) and has a simple process development, particularly when compared to compositions that thermally cure such as PDMS based systems.

In one embodiment, the elastomeric stamp includes a layer of the photosensitive composition wherein the fluorinated compound is a perfluoropolyether (PFPE) compound. A perfluoropolyether compound is a compound that includes at least a primary proportion of perfluoroether segments, i.e., perfluoropolyether. The primary proportion of perfluoroether segments present in the PFPE compound is equal to or greater than 80 weight percent, based on the total weight of the PFPE compound. The perfluoropolyether compound may also include one or more extending segments that are hydrocarbons or hydrocarbon ethers that are not fluorinated; and/or, are hydrocarbons or hydrocarbon ethers that may be fluorinated but are not perfluorinated. In one embodiment, the perfluoropolyether compound includes at least the primary proportion of perfluoropolyether segments and terminal photoreactive segments, and optionally extending segments of hydrocarbon that are not fluorinated. The perfluoropolyether compound is functionalized with one or more terminal ethylenically unsaturated groups that render the compound reactive to the actinic radiation (i.e., photoreactive segments). The photoreactive segments may also be referred to as photopolymerizable segments.

The perfluoropolyether compound is not limited, and includes linear and branched structures, with linear backbone structures of the perfluoropolyether compound being preferred. The PFPE compound may be monomeric, but typically is oligomeric and a liquid at room temperature. The perfluoropolyether compound may be considered an oligomeric difunctional monomer having oligomeric perfluoroether segments. Perfluoropolyether compounds photochemically polymerize to yield the elastomeric layer of the stamp. An advantage of the PFPE based materials is that PFPEs are highly fluorinated and resist swelling by organic solvents, such as methylene chloride, chloroform, tetrahydrofuran, toluene, hexanes, and acetonitrile among others, which are desirable for use in microcontact printing techniques.

Optionally, the elastomeric stamp may include a support of a flexible film, and preferably a flexible polymeric film. The flexible support is capable of conforming or substantially conforming the elastomeric relief surface of the stamp to a printable electronic substrate, without warping or distortion. The support is also sufficiently flexible to be able to bend with the elastomeric layer of the stamp while peeling the stamp from the master. The support can be any polymeric material that forms a film that is non-reactive and remains stable throughout conditions for making and using the stamp. Examples of suitable film supports include cellulosic films such as triacetyl cellulose; and thermoplastic materials such as polyolefins, polycarbonates, polyimides, and polyester. Preferred are films of polyethylene, such as polyethylene terephthalate and polyethylene napthalate. Also encompassed within a support is a flexible glass. Typically the support has a thickness between 0.0051 to 0.13 cm (2 to 50 mils). Typically the support is in sheet form, but is not limited to this form. In one embodiment, the support is transparent or substantially transparent to the actinic radiation at which the photosensitive composition polymerizes.

Optionally, the elastomeric stamp may include one or more layers on the relief surface prior to the application of the mask material. The one or more layers may, for example, assist in the transfer of the mask material from the stamp to the substrate. An example of a material suitable for use as the additional layer includes fluorinated compounds. In one embodiment, the additional layer remains with the elastomeric stamp after transfer of the mask material to the substrate.

A mask material is provided on the stamp by applying the mask material to at least the raised surface of the relief structure of the stamp. The mask material can be applied to the stamp by any suitable method, including but not limited to, injection, pouring, liquid casting, jetting, immersion, spraying, vapor deposition, and coating. Examples of suitable methods of coating include spin coating, dip coating, slot coating, roller coating, and doctor blading. In one embodiment, the mask material is applied to the relief structure of the stamp, that is, the mask material forms a layer on the raised surface/s and the recessed surface/s. The layer of mask material on the stamp can be continuous or discontinuous. The thickness of the layer of mask material is not particularly limited, provided that the material can print and function as a mask on the substrate. In one embodiment, the thickness of the mask material layer is typically less than the relief height (difference between the raised surface and the recessed surface) of the stamp. In one embodiment, the layer of mask material on the stamp is between 0.01 and 1 µm.

After the mask material has been applied to at least the raised surface of the stamp, the mask material may optionally be dried to remove some or all of a carrier or solvent prior to transferring to the substrate. Drying may be accomplished in any manner, including, using gas jets, blotting with an absorbent material, evaporation at room temperature or an elevated temperature, etc. In one embodiment the mask material is substantially free of solvent or carrier before transferring and forms a film on the raised surface.

The selection of mask material is driven by the functional material that will ultimately be patterned. The mask material is typically dispersed or dissolved or suspended in solution for application to the stamp. The functional material is also typically dispersed or dissolved or suspended in solution for application to the substrate. The type of solution used for the functional material, whether an organic or aqueous or alcohol based compound, determines the mask material and the corresponding solution that the mask material is dispersed or dissolved or suspended in. The mask material should not use the same or substantially the same or similar solution that the functional material uses. The solution may be a solvent, that is a substance which is capable of dissolving another substance to form a uniformly dispersed mixture, or may be a carrier compound capable of dispersing or suspending the material in solution sufficient to conduct the steps of the present method.

In particular embodiments, the solution for the mask material is incompatible or substantially incompatible with the solution of the functional material. That is, in one embodiment if the functional material is in solution with an organic compound, the mask material is selected to be incompatible or substantially incompatible with organic solutions, (i.e., the mask material is dispersed or dissolved or suspended in aqueous or alcohol solution). In one embodiment, if the functional material is in solution with an aqueous or alcohol compound, the mask material is selected to be incompatible or substantially incompatible with aqueous or alcohol solutions, (i.e., the mask material is dispersed or dissolved or suspended in an organic material). In one embodiment, the mask material and the functional material are incompatible or substantially incompatible, such that the functional material when applied on the pattern of mask material on the substrate, does not or substantially does not alter or disrupt or otherwise impact the pattern of mask material. In another embodiment, the mask material and the functional material are incompatible or substantially incompatible such that the functional material and the mask material do not intermingle or dissolve when adjacent to one another. In another embodiment, the mask material and functional material are incompatible or substantially incompatible such that removal of the mask material by a solvent solution (after application of the functional material) does not disturb the formation of the pattern of functional material on the substrate. Examples of altering or disrupting the pattern include dissolving or swelling the mask material and lifting the mask material from the substrate (when in contact with the functional material); and dissolving or swelling the functional material and lifting of the functional material from the substrate (particularly when the masking material is being removed from the substrate). It is also contemplated within the bounds of the present method that the mask material and the functional material both may use the same generic solution, e.g., both use an organic solution, or both use an alcohol solution, and still be incompatible or substantially incompatible. In this case provided that the solubility of the mask material solution and the functional material solution are different enough that the application of the functional material does not detrimentally impact the pattern of mask material on the substrate, and the removal of the mask material does not detrimentally impact the formation of the pattern of functional material, the mask material and the functional material are considered substantially incompatible (See Examples 1 and 3.)

The mask material should be capable of (1) forming a layer on at least the raised surface of the relief structure of stamp; (2) transferring a pattern according to the relief structure to the substrate; and (3) removing from the substrate without detrimentally impacting the functional material (and without impacting an underlying layer, if present). Certain properties of the elastomeric stamp, may influence the capability of a particular mask material to form a layer and transfer to the substrate, but it is well within the skill of those in the art of microcontact printing to determine an appropriate combination of mask material and elastomeric stamp. In one embodiment, the mask material also allows the functional material to cover in whole or in part the mask pattern.

Materials suitable as the mask material are not limited provided that the mask material meets the above requirements. Examples of materials suitable for use as the mask material for functional materials that are in aqueous or water solution, include but are not limited to, acrylonitrile homopolymers and copolymers, such as acrylonitrile-butadiene elastomers, and poly(acrylonitrile); styrene homopolymers and copolymers, such as, polystyrene, and poly(styrene-acrylonitrile) copolymers; homopolymers and copolymers of acrylates and methacrylates, such as polyacrylate, poly(ethyl methacrylate), and polymethacrylate; polycarbonates; polyurethanes; polythiophenes; substituted and unsubstituted polyphenylene-vinylene homopolymers and copolymers; poly(4-vinyl pyridine); poly(n-hexyl isocyanate); poly(1,4-phenylene vinylene); epoxy-based systems; poly(n-carbazole); homopolymers and copolymers of polynorbornene; poly(phenylene oxide); poly(phenylene sulfide); poly(tetrafluoroethylene); and combinations and copolymers thereof.

Examples of materials suitable for use as the mask material for functional materials that are in organic solution, include but are not limited to, alkyd resins; gelatin; poly(acrylic acid); polypeptides; proteins; poly(vinyl pyridine); poly(vinyl pyrrolidone); hydroxy polystyrene; poly(vinyl alcohol); polyethylene glycol; chitosan; poly(styrene-co-vinyl pyridine); poly(butyl acrylate-co-vinyl pyridine); aryl amines and fluorinated aryl amines; cellulose and cellulose derivatives; dispersions of acrylate and/or methacrylate emulsions; and combinations and copolymers thereof.

Transferring the mask material from the raised surface of the relief structure to the substrate creates a pattern of the mask material on the substrate and correspondingly forms a pattern of open area on the substrate. Transferring may also be referred to as printing. Contacting the mask material on the raised surface to the substrate transfers the mask material, such that the pattern of mask material forms when the stamp is separated from the substrate. In one embodiment, all or substantially all the mask material positioned on the raised surface(s) transfer to the substrate. The separation of the stamp from the substrate may be accomplished by any suitable means, including but not limited to peeling, gas jets, liquid jets, mechanical devices etc. Optionally pressure may be applied to the stamp to assure contact and complete transfer of the mask material to the substrate. Transfer of the mask material to the substrate may be accomplished in any manner. Transferring the mask material may be by moving the relief surface of the stamp to the substrate, or by moving the substrate to the relief surface of the stamp, or by moving both the substrate and the relief surface into contact. In one embodiment, the mask material is transferred manually. In another embodiment, the transfer of the mask material is automated, such as, for example, by a conveyor belt; reel-to-reel process; directly-driven moving fixtures or pallets; chain, belt or gear-driven fixtures or pallets; a frictional roller; printing press; or a rotary apparatus. The thickness of the layer of masking material is not particularly limited, with typical thickness of the layer of mask material on the substrate between 0.01 to 1 µm, (100 to 10000 angstrom).

The substrate is not limited, and can include, plastic, polymeric films, metal, silicon, glass, fabric, paper, and combinations thereof, provided that the mask pattern can be formed thereon. The substrate can be opaque or transparent. The substrate can be rigid or flexible. The substrate may include one or more layers and/or one or more patterns of other materials, before the pattern of the functional material according to the present method is formed on the substrate. A surface of the substrate can include an adhesion-promoting surface, such as a primer layer, or can be treated to promote adhesion of an adhesive layer, or the masking material, or functional material to the substrate. Suitable substrates include, for example, a metallic film on a polymeric, glass, or ceramic substrate, a metallic film on a conductive film or films on a polymeric substrate, metallic film on a semiconducting film on a polymeric substrate. Further examples of suitable substrates include, for example, glass, indium-tin-oxide coated glass, indium-tin-oxide coated polymeric films; polyethylene terephthalate, polyethylene naphthalate, polyimides , silicon, and metal foils.

After the pattern of mask material is formed on the substrate, the functional material is applied to the substrate, in at least the open area or areas between the mask pattern. In one embodiment, the functional material is applied to cover the surface of the substrate, that is, over the mask pattern and the open area/s on the substrate. In another embodiment, the functional material is applied selectively to cover at least the open area or areas on the substrate (where no pattern of mask material resides). Selective application of the functional material can be carried out by jetting, for example. The functional material can be applied to the substrate by any suitable method, including but not limited to, injection, pouring, liquid casting, jetting, immersion, spraying, vapor deposition, and coating. Examples of suitable methods of coating include spin coating, dip coating, slot coating, roller coating, and doctor blading.

After the functional material has been applied to the substrate, the functional material can be dried to remove some or all of the carrier or solvent prior to removal of the mask pattern from the substrate. Drying may be accomplished in any manner, including, using gas jets, blotting with an absorbent material, evaporation at room temperature or an elevated temperature, etc. In one embodiment, the functional material is substantially free of solvent or carrier and forms a film on the surface of the substrate.

A functional material is a material that is patterned for use in microfabrication of electronic components and devices. The functional material is not limited, and includes, for example, conductive materials, semi-conductive materials, dielectric materials, etc. Examples of conductive materials for use as a functional material include, but are not limited to, indium-tin oxide; metals, such as silver, gold, copper, and palladium; metal complexes; metal alloys; etc. Examples of semiconductive materials include, but are not limited to, silicon, germanium, gallium arsenide, zinc oxide, and zinc selenide.

The functional material can be of any form including particulate, polymeric, molecular, etc. Typically, semiconducting materials and dielectric materials are polymeric, but are not limited to this form, and functional materials can include soluble semiconducting molecules.

Functional materials for use in the present method also include nanoparticles of conductive, semi-conductive, and dielectric materials. Nanoparticles are microscopic particles whose size is measured in nanometers (nm). Nanoparticles include particles having at least one dimension less than 200 nm. In one embodiment, the nanoparticles have a diameter of about 3 to 100 nm. At the small end of the size range, the nanoparticles may be referred to as clusters. The shape of the nanoparticles is not limited and includes nanospheres, nanorods, and nanocups.. Nanoparticles made of semiconducting material may also be called quantum dots, if the particles are small enough (typically less than 10 nm) that quantization of electronic energy levels occurs. Semiconducting materials include light-emitting quantum dots. A bulk material generally has constant physical properties regardless of its size, but for nanoparticles this is often not the case. Size dependent properties are observed such, as quantum confinement in semiconductor particles, surface plasmon resonance in some metal particles and superparamagnetism in magnetic materials. The functional material includes but is not limited to semi-solid nanoparticles, such as liposome; soft nanoparticles; nanocrystals; hybrid structures, such as core-shell nanoparticles. The functional material includes nanoparticles of carbon, such as carbon nanotubes, conducting carbon nanotubes, and semiconducting carbon nanotubes. Metal nanoparticles and dispersions of gold, silver and copper are commercially available from Nanotechnologies, and ANP.

In one embodiment, the functional material is in solution for application to the substrate. In another embodiment, the functional material is liquid and need not be in solution for application to the substrate. The functional material, particularly when in the form of nanoparticles, is suspended in a carrier system. As was described above in one embodiment, the solvent or carrier system for the functional material should be incompatible or substantially incompatible with the mask material transferred onto the substrate. In another embodiment, the functional material is at least incompatible or substantially incompatible with a solvent solution used for the subsequent removal of the mask material.

After the functional material is applied to the substrate and forms a film, the mask pattern is removed from the substrate. Removing the pattern of the mask material can be accomplished by any method including, but not limited to, immersion or wetting with a solvent solution, and exposure to laser radiation. Exposure of the mask material on the substrate to laser radiation is not limited to any particular mechanism to remove the mask pattern, which can include but is not limited to, ablating the mask material off the substrate, altering the adhesion balance of the mask material to the substrate by swelling, lifting, or transfering the mask material. In one embodiment, the pattern of mask material is removed from the substrate by immersing the substrate in a bath of a solvent for the mask material for a period of time sufficient to cause separation of the mask pattern and the substrate. Removal by the solvent may cause the mask pattern in whole or in part to lift, swell, dissolve, disperse, or combinations thereof into the solvent solution. Optionally, the removal of the mask material may be aided by sonication, that is, the application of intense sound waves to the solvent solution. Sonication may also be called sonic cleaning. In one embodiment, the functional material that covers in whole or in part the pattern of mask material is also removed at the same time as the mask material. In another embodiment, the functional material that covers the mask pattern may be removed separately from removal of the mask material. Removal of the mask material should not disrupt or disturb the functional material that is in contact with the substrate (or with an underlying layer that is not the mask material). If the application of the functional material formed a layer on the substrate over both the mask pattern and the open area/s on the substrate, the removal of the mask pattern (and the overlying functional material) results in the formation of the pattern of the functional material on the substrate.

Although the present method can be used to form any pattern layer of an electronic device or component, the method is particularly useful to form an initial pattern of the functional material. In substrates having more than one additional layers underlying the presently applied functional material, care must be taken in choosing the solvent solution to remove the mask material such that the underlying layers are not impacted or disrupted by contact with the solvent for the mask material.

Optionally, the susbstrate having the pattern of functional material may undergo further treatment steps such as, heating, exposing to actinic radiation sources such as ultraviolet radiation and infrared radiation, etc. The treating step can occur after or just prior to the removing step. In an embodiment where the functional material is in the form of nanoparticles, the additional treatment step may be necessary to render the functional material operative. For instance, when the functional material is composed of metal nanoparticles, the pattern of functional material must be heated to sinter the particles and render the lines of the pattern conductive.

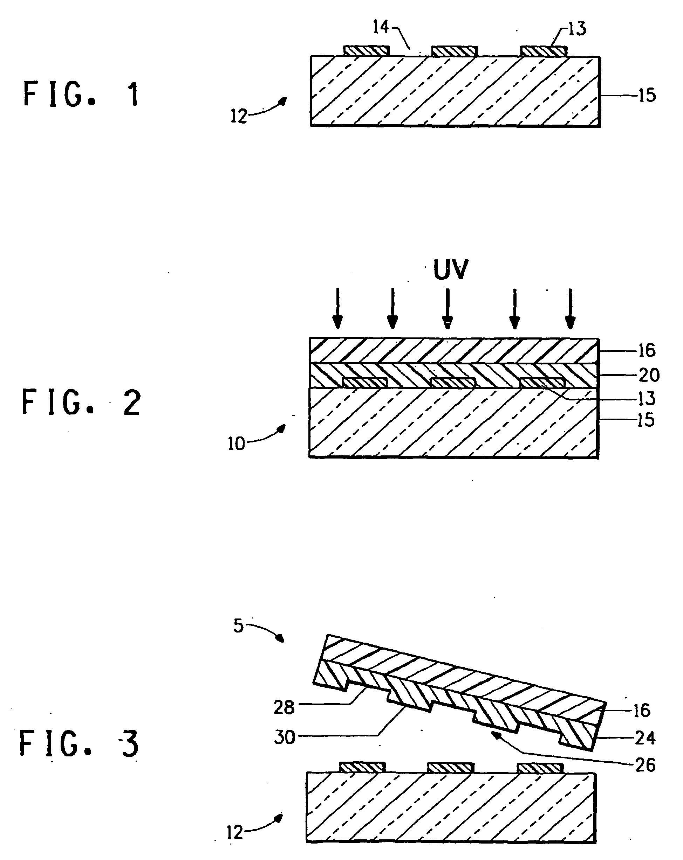

Referring to Figures 1 through 3, one embodiment of a method of preparing a stamp 5 from a stamp precursor 10 occurs in a molding operation. Figure 1 depicts a master 12 having a pattern 13 of a negative relief of the microelectronic features formed on a surface 14 of a master substrate 15. The master substrate 15 can be any smooth or substantially smooth metal, plastic, ceramic or glass. In one embodiment the master substrate is a glass or silicon plane. Typically the relief pattern 13 on the master substrate 15 is formed of a photoresist material, according to conventional methods that are well within the skill in the art. Plastic grating films and quartz grating films can also be used as masters. If very fine features on the order of nanometers are desired, masters can be formed on silicon wafers with e-beam radiation.

The master 12 may be placed in a mold housing and/or with spacers (not shown) along its perimeter to assist in the formation of a uniform layer of the photosensitive composition. The process to form the stamp can be simplified by not using the mold housing or spacers.

In one embodiment shown in Figure 2, a photosensitive composition is introduced to form a layer 20 onto the surface of the master 12 having the relief pattern 13. The photosensitive composition can be introduced on to the master 12 by any suitable method, including but not limited to, injection, pouring, liquid casting and coating. In one embodiment, the photosensitive composition is formed into the layer 20 by pouring the liquid onto the master. The layer of the photosensitive composition 20 is formed on the master 12 such that after exposure to actinic radiation, the cured composition forms a solid elastomeric layer having a thickness of about 5 to 50 µm. A support 16 is positioned on a side of the photosensitive composition layer 20 opposite the master 12 such that an adhesive layer if present, is adjacent the layer of the photosensitive composition, to form the stamp precursor 10. The support 16 can be applied to the composition layer in any manner suitable to attain the stamp precursor 10. Upon exposure to actinic radiation, which is ultraviolet radiation in the embodiment shown, through the transparent support 16 of the stamp precursor 10, the photosensitive layer 20 polymerizes and forms an elastomeric layer 24 of the composition for the stamp 5. The layer of the photosensitive composition 20 cures or polymerizes by exposure to actinic radiation. Further, typically the exposure is conducted in a nitrogen atmosphere, to eliminate or minimize the presence of atmospheric oxygen during exposure and the effect that oxygen may have on the polymerization reaction.

The printing form precursor can be exposed to actinic radiation, such as an ultraviolet (UV) or visible light, to cure the layer 20. The actinic radiation exposes the photosensitive material through the transparent support 16. The exposed material polymerizes and/or crosslinks and becomes a stamp or plate having a solid elastomeric layer with a relief surface corresponding to the relief pattern on the master. In one embodiment, suitable exposure energy is between about 10 and 20 Joules on a 365nm I-liner exposure unit.

Actinic radiation sources encompass the ultraviolet, visible, and infrared wavelength regions. The suitability of a particular actinic radiation source is governed by the photosensitivity of the photosensitive composition, and the optional initiator and/or the at least one monomer used in preparing the stamp precursor. The preferred photosensitivity of stamp precursor is in the UV and deep visible area of the spectrum, as they afford better room-light stability. Examples of suitable visible and UV sources include carbon arcs, mercury-vapor arcs, fluorescent lamps, electron flash units, electron beam units, lasers, and photographic flood lamps. The most suitable sources of UV radiation are the mercury vapor lamps, particularly the sun lamps. These radiation sources generally emit long-wave UV radiation between 310 and 400 nm. Stamp precursors sensitive to these particular UV sources use elastomeric-based compounds (and initiators) that absorb between 310 to 400 nm.

As shown in Figure 3, the stamp 5, which includes the support 16, is separated from the master 12 by peeling. The support 16 on the stamp 5 is sufficiently flexible in that the support and the stamp can withstand the bending necessary to separate from the master 12. The support 16 remains with the cured elastomeric layer 24 providing the stamp 5 with the dimensional stability necessary to reproduce micropatterns and microstructures associated with soft lithographic printing methods. The stamp 5 includes on a side opposite the support 16 a relief surface 26 having recessed surfaces 28 and raised surfaces 30 corresponding to the negative of the relief pattern 13 of the master 12. The relief surface 26 has a difference in height between the raised portion 30 and the recessed portion 28, that is a relief depth. The relief structure 26 of the stamp 5 forms a pattern of raised surfaces 30 for printing a mask material 32 on a substrate 34 and recessed surface portions 28 which will not print.

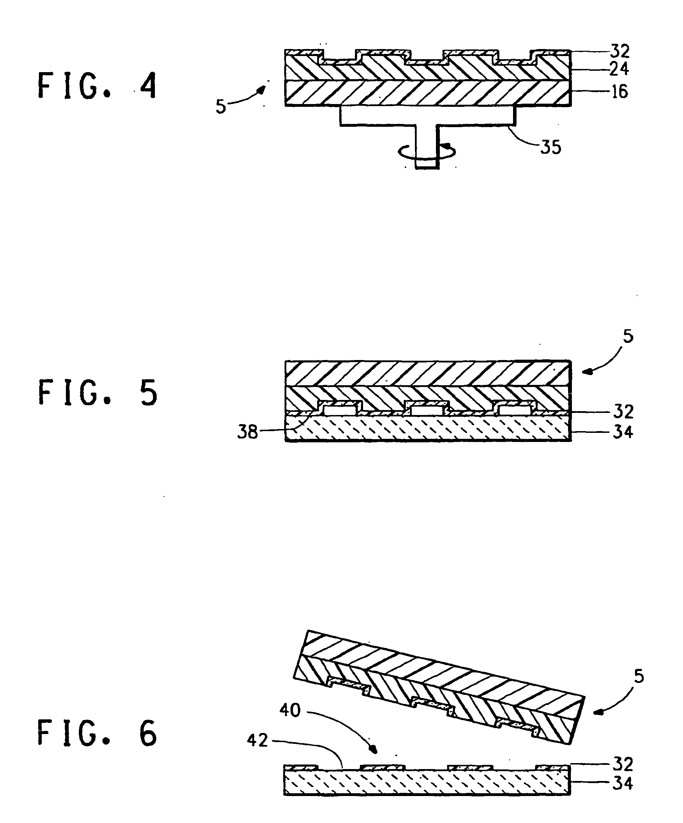

In Figure 4, the stamp 5 resides on a platform 35 of a spin coating device as one embodiment for applying the mask material 32 onto the relief structure 26 of the stamp 5. The mask material 32 is applied to the relief structure 26 of the stamp 5 and the platform is rotated to form a relatively uniform, continuous layer of the mask material.

In Figure 5, the stamp 5 having the layer of mask material 32 and the substrate 34 are positioned adjacent one another so that the mask material on the raised surfaces 30 of the stamp 5 contact a surface 38 of the substrate 34.

In Figure 6, the stamp 5 is separated from the substrate 34, and the mask material 32 contacting the substrate remains on the substrate, transferring to form a pattern 40 of the mask material. The substrate 34 includes the pattern 40 of mask material 32 and open areas 42 where no mask material resides.

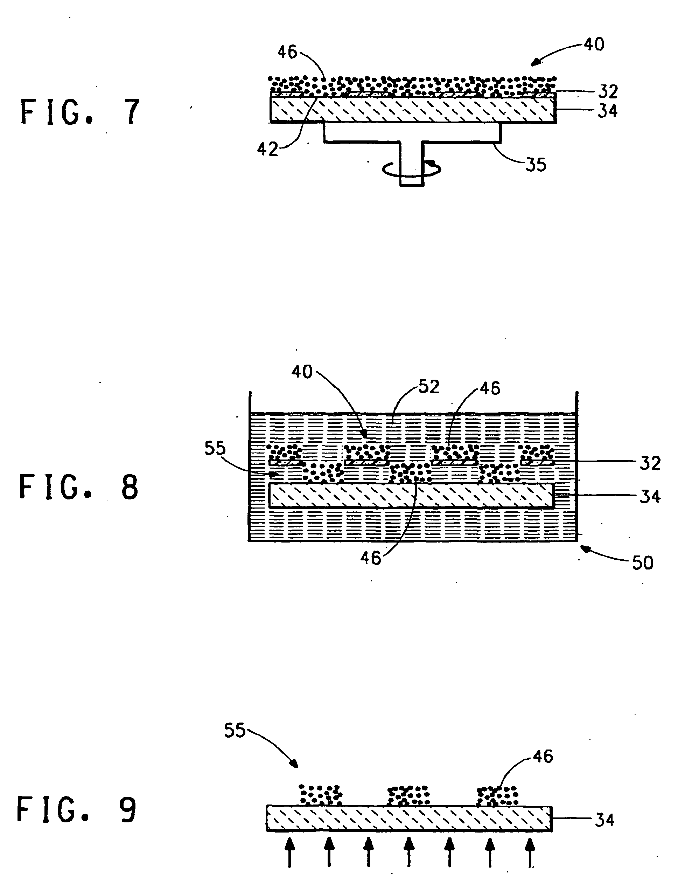

In Figure 7, the substrate 34 with mask pattern 40 resides on the platform 35 of a spin coating device as one embodiment for applying a functional material 46 to the substrate. The functional material 46 is applied to a side of the substrate 34 having the mask pattern 40, and the platform 35 is rotated to form a relatively uniform, continuous layer of the functional material 46 on the substrate. In the embodiment shown, the layer of functional material 46 covers both the pattern 40 of mask material 32 and the open areas 42.

In Figure 8 the substrate 34 having the layer of the functional material 46 and the mask pattern 40 is placed in a bath 50 containing a solution 52 that is a solvent for the mask material 32. The pattern 40 of mask material 32 lifts off from the substrate 34 and/or dissolves in the solution bath 50. The functional material 46 that resided on the mask pattern 40 also is removed with the mask material 32, and the functional material 46 that resided in the open areas 42 remains on the substrate 34. The functional material 46 that resides on the substrate 34 in the open areas 42 creates a pattern 55 of functional material 46 for the electronic device or component.

In Figure 9, the substrate 34 with the pattern 55 of functional material 46 is being heated as one embodiment of further treating. In this embodiment, the functional material 46 is metal nanoparticles that need to be sintered by heating in order to render the pattern 55 conductive.

### EXAMPLES

Unless otherwise indicated, all percentages are by weight of the total composition.

### Example 1

The following example demonstrates a method to form a pattern on a substrate. Silver nanoparticles are formed into a pattern onto a flexible base that can provide a functional source-drain level of a thin film transistor.

### Master Preparation:

A thin hexamethyldisilazane layer (HMDS) (from Aldrich) was spun coated onto a 5.1 cm (2 inch) silicon wafer at 3000 revolutions/min for 60 seconds. The HMDS is an adhesion promoter for a photoresist material on a silicon wafer. A Shipley positive photoresist, type1811 (from Rohm and Haas) was spun coated onto the HMDS layer at 3000 revolutions/min for 60 seconds. The photoresist film was pre-baked on a hotplate at 115°C for 1 minute to complete drying. The pre-baked photoresist film was then imagewise exposed through a photomask to ultraviolet radiation of 365 nm for 8 seconds in an I-liner (OAI Mask Aligner, Model 200). After exposure the photoresist was developed in developer type MF-319 (from Rohm and Haas) which is tetramethyl ammonium hydroxide (TMAH) solution for 60 seconds. The developed film was washed in distilled water, dried with nitrogen, and heated on the hotplate to 115°C for 5 minutes, to form the master with a relief pattern. The relief pattern on the prepared master had raised surface areas and recessed areas. The raised surface areas in the master form a positive image that will be the pattern of the functional silver material formed on the substrate. The thickness of the layer of the patterned photoresist master was 1.1 µm as measured with a surface Profiler (KIA-Tencor, San Jose, CA). The HMDS remained in the recessed areas on the master.

### Elastomeric stamp preparation:

A support for the elastomeric stamp was prepared by applying a layer of a UV curable optically-clear adhesive, type NOA73, (purchased from Norland Products; Cranbury, NJ) at a thickness of 5 µm onto a 0.0127 cm (5 mil) Melinex® 561 polyester film support by spin coating at 3000 rpm and then curing by exposure to ultraviolet radiation (350-400 nm) at 1.6 watts power (20 mWatt/cm²) for 90 seconds in a nitrogen environment.

A perfluoropolyether (PFPE) compound, E10-DA was supplied by Sartomer (Exton, PA) as product type CN4000 and was used as received. The E10-DA has the following structure

R-E-CF₂-O-(CF₂-O-)ₙ(-CF₂-CF₂-O-)ₘ-CF₂-E'-R'

wherein R and R' are each an acrylate, E is a linear non-fluorinated hydrocarbon ether of (CH₂CH₂O)₁₋₂CH₂, and E' is a linear hydrocarbon ether of (CF₂CH₂O(CH₂CH₂O)₁₋₂, and having a molecular weight of about 1000. The E10-DA is identified as a PFPE diacrylate prepolymer.

The elastomeric stamp composition was prepared by mixing the PFPE diacrylate prepolymer (MW 1000) and 1% by weight of a photoinitiator photoinitiator, Darocur 1173 (from Ciba Specialty Chemicals, Basel, Switzerland). The structure of Darocur 1173 is as follows. 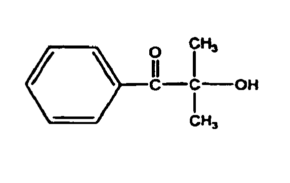 The mixture was filtered using a 0.45 micrometer PTFE filter. The filtered prepolymer was poured to form a layer on the side of the prepared master having the relief pattern. The support was placed on the PFPE prepolymer layer opposite the master (air-layer interface), such that the adhesive was in contact with the layer. The PFPE layer was exposed through the support using the 365 nm I-liner for 10 minutes under a nitrogen atmosphere, to cure or polymerize the PFPE layer and form a stamp. The stamp was then peeled from the master and had a relief surface that was the opposite of the relief pattern in the master. Thus the relief surface on the stamp was the negative of the desired pattern of functional material. (That is, the stamp had raised surface portions and recessed portions, in which the recessed surface portions correspond to the pattern of silver that will ultimately be formed.)
The relief pattern on the stamp had raised portions having height of 0.4 µm and having widths that varied from 5 µm to 500 µm; and had recessed portions having width that varied from 2 µm to 20000 µm**.**

### Transfer of mask material:

A mask material of 0.5% by weight solution of Covion Super-Yellow™, a substituted polyphenylene-vinylene 1-4 copolymer (from Merck), was dissolved in toluene and filtered using a 1-µm PTFE filter. The mask material solution was spun coated onto the relief surface of the prepared PFPE stamp at 3000 revolutions/min for 60 seconds. The solution covered the entire relief surface, and was allowed to dry in air at room temperature for about 1 minute. The substrate a 0.0127 cm (5 mil) Melinex® film type ST504 was placed on a hotplate maintained at 65°C. The PFPE stamp having the layer of the mask material was laminated onto an acrylic side of the substrate (while on the hotplate) without applying any additional pressure. The stamp and the substrate were removed from the hotplate, and the stamp was separated from the substrate at room temperature. The sacrificial masking material on the raised surface of the relief pattern of the elastomeric stamp transferred to the substrate and formed a mask pattern on the substrate. Recessed areas in the stamp did not contact the substrate, and therefore the substrate had open areas where there was no mask material. The pattern of masking material had a thickness of 27nm as measured with a profiler. The mask pattern of the printed sacrificial masking material was the positive of the pattern on the master (that is, the printed mask pattern is the same as the pattern of recessed areas of the master).

### Patterning of functional material:

A silver ink with 45% solids type DGP-MP-40LT was purchased from Anapro (Korea). The silver ink had silver nanoparticles of 50 nm diameter. The ink was diluted to 17% by weight with ethanol. The diluted silver dispersion was then sonicated for 5 minutes with a tip sonicator and filtered twice with a 0.2 µm PTFE filter. The silver dispersion was spun coated onto the substrate having the mask pattern of the sacrificial material at 3000 revolutions/min for 60 seconds. The entire surface of the substrate was covered by the silver dispersion, that is silver material was deposited as a layer on the mask pattern and the open areas. The silver was then annealed at 65°C for 1 minute to remove the solvent and sintered at 140°C for 5 minutes on a hotplate. The substrate with mask and functional layer was placed in a chloroform bath and the bath was sonicated for 1 minute to lift-off the mask. The lift-off of the sacrificial mask material from the substrate also carried the silver that was deposited on top of the mask, but did not affect the silver that was directly applied to the substrate. A pattern of the functional silver material remained on the substrate. The silver pattern on the substrate was washed in isopropyl alcohol (IPA) and distilled water, and dried with a nitrogen gun.

The silver pattern on the substrate created a component containing interdigitated source drains lines. The line widths were 5 µm. The separation between source drain lines was 2 µm. The silver pattern lines had a resistivity of less than 2 ohm/sq.

Patterning by this method lead to source drain lines without breaks or undesired particulate. Unlike standard microcontact printing (see comparative Example) there was no undesired transfer of the silver onto nominally clean background area. The lines were quite crisp and the image was similar to an image obtained by photolithographic methods.

### Example 2

The following example demonstrates the method of forming a pattern of functional material using an elastomeric stamp to print a sacrificial mask material. The functional material is silver nanoparticles that form a pattern on a flexible film substrate.

The master and the elastomeric stamp were prepared as described in Example 1. The relief pattern on the stamp had the same dimensions as those reported for Example 1.

### Transfer of sacrificial material:

A sacrificial mask material of a poly(4-vinyl pyridine) (P4VP) solution (from Aldrich, in St Louis, MO) was prepared by dissolving the 1 % by weight of the P4VP polymer in chloroform (CCl₃H) and filtered with 0.2 µm PTFE filter. The P4VP solution was spun coated onto the elastomeric PFPE stamp at 3000 revolutions/min for 60 seconds, and air dried for about 1 minute. The P4VP on the PFPE stamp was then printed onto an acrylic coated side of a 0.0127 cm (5 mil) Melinex® film type ST504 as the substrate, at room temperature without applying any additional pressure to the stamp. The stamp was separated from the substrate at room temperature resulting in the transfer of the P4VP from the raised surfaces of the stamp's relief pattern onto the substrate. The thickness of P4VP pattern was 30 nm when measured with profiler.

### Patterning of functional material:

Silver ink, type DGH with 45% solids by weight, was purchased from Anapro (Korea). The silver ink had silver nanoparticles of about 20 nm in diameter. The ink was diluted to 18% by weight with toluene. The dilute silver dispersion was then sonicated for 10 minutes using tip a sonicator and filtered twice with 0.2 µm PTFE filter. The silver solution was spun coated onto the substrate having the mask pattern of the sacrificial P4VP material at 2000 revolutions/min for 60 seconds. The entire surface of the substrate was covered by the silver dispersion, that is, the silver material was deposited as a layer on the mask pattern and the open areas. The silver layer was then annealed at 130°C for 10 minutes on a hotplate. The substrate with mask and functional layer was placed in a methanol (MeOH) bath and the bath was sonicated for 1 minute to lift-off the mask. The lift-off of the sacrificial P4VP material from the substrate also carried the silver that was deposited on top of the mask, but did not affect the silver that was directly spun onto the substrate. The silver pattern on the substrate was washed with fresh methanol and distilled water, and dried with a nitrogen gun. The silver pattern on the substrate was sintered at 140°C for 48 hours. The silver pattern lines had a resistivity of 4.4 ohm/square.

Prolonged heating of the 20nm silver particles sintered them into a conducting film on the substrate. Although the DGH type of silver nanoparticles can quickly sinter at a temperature of about 250°C, the Melinex® PET substrate would be destroyed the sintering temperature. So sintering of the silver lines occurred at a lower temperature suitable for the substrate to withstand and for a longer time period. However, extended heating of the substrate led to low molecular weight oligomers from the substrate, which are micronmeters in diameter, to diffuse as loose particles onto the surface of the substrate.

The substrate with sintered silver lines was washed in acetone to remove the loose particles from the substrate. The resulting pattern of functional silver material was particle free. The silver pattern on the substrate created a source-drain level of 20 transistors each with 17 interdigitated source-drain lines. The patterns comprise 5 µm lines and 3, 5, and 8-µm channels.

Detail images of the pattern created of interdigitated source drain with 5 µm lines and spaces, before and after the acetone wash, were reviewed. It was clearly observed that the particles (0.5-5 µm in size) had formed on the substrate surface upon prolonged heating. The number of particles varied throughout the surface, since the left electrode of the source drain had about 50 particles and the right electrode of the drain had fewer particles. The number of particles on each line varied as well. The pre-wash image shows between 1-10 particles per line. In the image of the interdigitated source drain after the acetone rinse, the silver pattern lines were clean and no particles or breaks in the lines were observed.

### Example 3

The following example demonstrates the method for forming a pattern of a functional material onto a flexible film. The functional material is an organic semiconducting material of a polythiophene.

The master and the elastomeric stamp were prepared as described in Example 1.

### Transfer of mask material:

A solution of 10% by weight of TFE-NB-f-OH copolymer (2-Propanol, 2-[(bicyclo[2.2.1]hept-5-en-2-yloxy)methyl]-1,1,1,3,3,3-hexafluoro-) polymer as shown in the following structure with tetrafluoroethene dissolved in acetone was prepared.

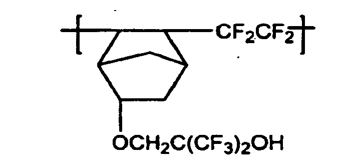

A mask material of a solution of 1% by weight of Elvacite® 2042, a poly(ethyl methacrylate), (from Lucite) dissolved in acetone was prepared. 10g of the TFE-NB-f-OH solution was mixed with 1 g of the Elvacite solution to form a mixture of a sacrificial masking material. The mask material mixture was spun coated onto the PFPE elastomeric stamp at 5000 revolutions/min for 60 seconds and dried in air. The mask material on the PFPE stamp was contacted to an acrylic coated side of a 0.0127 cm (5 mil) Melinex® film type ST504 as the substrate, located on a hotplate at 65°C. A small amount of pressure (∼ 689N/m², ∼0.1 lbs/psi) was applied manually in the transfer. The stamp was separated from the substrate resulting in the transfer of the mask material from the raised surfaces of the of the relief pattern of the stamp onto the substrate.

### Patterning of functional material:

A solution of 0.5% by weight of the polythiophene in chloroform was spun coated onto the substrate at 5000 revolutions/min for 60 seconds. The entire surface of the substrate was covered by the polythiophene solution, that is, the polythiophene was deposited as a layer on the mask pattern and
the open areas. The substrate with the mask and the layer of the functional material were placed in an acetone bath, and the bath was sonicated for 10 seconds to lift-off the pattern of the mask material beneath the polythiopene layer.

The lift-off of the mask material from the substrate also carried the polythiophene material that was deposited on top of the mask, but did not affect the polythiophene material that was spun directly onto the substrate. No extraneous silver material was left or deposited between the pattern lines of silver. The pattern lines of the polythiophene were about 200 µm in width and appeared to show some particulate.

### Example 4

The following example demonstrates the method of forming a pattern of functional material using an elastomeric stamp to print a sacrificial mask material. The functional material is silver nanoparticles that form a pattern on a flexible film substrate.

The master and the elastomeric stamp were prepared as described in Example 1. The relief pattern on the stamp had the same dimensions as those reported for Example 1. The raised portions of 5 to 500 µm in width and 0.4 µm in height, and the recessed portions of 2 to 20000 µm width and 0.4 µm in height.

### Transfer of sacrificial material:

A mask material was prepared. A 1% by weight of a triarylamine polymer was prepared in toluene. The triarylamine polymer was prepared according to the following structure as described in Example 1 by Herron et al., published PCT application WO 2005/080525: 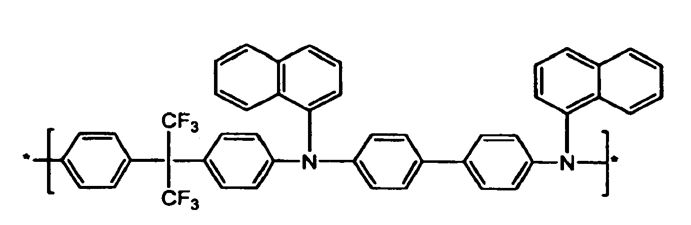 A 1% by weight solution of Elvacite® type 2045, a poly(iso-butyl methacrylate) was prepared in toluene. The mask material was prepared from the triarylamine polymer solution and poly(isobutyl methacrylate) solution at 90 /10 weight ratio and filtered with 0.2 µm PTFE filter. The mask material solution was spun coated onto the elastomeric PFPE stamp at 3000 revolutions/min for 60 seconds, and air dried for about 1 minute. The film of the mask material on the PFPE stamp was then printed onto an acrylic coated side of a 0.0127 cm (5 mil) Melinex® film type ST504 as the substrate, at room temperature without applying any additional pressure to the stamp. The stamp was separated from the substrate at room temperature resulting in the transfer of the film of mask material from the raised surfaces of the stamp's relief pattern onto the substrate. The thickness of mask material pattern film was 40 nm when measured with profiler.

### Patterning of functional material:

A silver ink, type DGH with 45% solids by weight, was purchased from Anapro (Korea). The silver ink had silver nanoparticles of about 20 nm in diameter. The ink was diluted to 18% by weight with toluene. The dilute silver dispersion was then sonicated for 10 minutes using a tip sonicator and filtered twice with 0.2 µm PTFE filter. The silver solution was spun coated onto the substrate having the pattern of the mask material at 2000 revolutions/min for 60 seconds. The entire surface of the substrate was covered by the silver dispersion, that is, the silver material was deposited as a layer on the mask pattern and the open areas. The silver layer was then annealed at 130°C for 20 minutes on a hotplate. The substrate with mask and functional layer was placed in a chloroform (CHCl₃) bath and the bath was sonicated for 1 minute to lift-off the mask. The lift-off of the sacrificial mask material from the substrate also carried the silver that was deposited on top of the mask, but did not affect the silver that was directly spun onto the substrate. The silver pattern on the substrate was washed with fresh isopropyl alcohol and distilled water, and dried with a nitrogen gun. The silver pattern on the substrate was sintered at 140°C for 48 hours.

Detail images of the mask material pattern created of interdigitated source drain with 5 µm lines and 20 to 2 µm spaces, before and after the chloroform wash, were reviewed. The image of the mask pattern of the interdigitated source drain shows clean edges with the resolution of PFPE master. The resolution of the pattern silver was 5 µm lines and spaces.

### Comparative Example

The following comparative example demonstrates direct contact printing of a functional material wherein the functional material transfers to the substrate in featureless regions that should have no functional material.

### Master preparation:

A master was prepared with a pattern using a negative photoresist, SU-8 type 2 (from MICRO CHEM, Newton, MA) and the same photomask as used in Example 1. Thus, the stamp made from this master had the raised surface for direct printing the functional material onto the substrate. The photoresist was diluted with gamma butyrolactone with weight ratio of 7:3 and filtered using 1.0 µm of PTFE. The solution was spun coated onto a silicon wafer at 3000 revolutions/min dried at 65°C 1min and further pre-baked at 95°C for 1 min. The pre-baked photoresist was exposed with an I-liner (365nm) for 5 seconds followed by post-baking at 95°C hotplate for 1 min. The post-baked photoresist on the silicon wafer was developed in SU-8 developer (from MICRO CHEM) for 1 min, washed with isopropyl alcohol and distilled water, and dried with a nitrogen gun. The feature height of photoresist pattern was 400 nm when measured using profiler.

An elastomeric stamp made from this master was fabricated following the procedure described in Example 1.

### Transfer of functional material:

A silver ink, type DGH, with 45% solids by weight was purchased from Anapro (Korea). The ink was diluted to 18% by weight with toluene. The dilute silver dispersion was then sonicated for 10 minutes using tip a sonicator and filtered twice with 0.2 µm PTFE filter. The silver solution was spun coated onto the PFPE stamp at 2000 revolutions/min for 60 seconds. The entire surface of the stamp was covered by the silver dispersion. The silver layer was air dried for one minute and transferred onto an acrylic coated side of a substrate by applying a gentle pressure. The substrate was a 0.0127 cm (5 mil) Melinex® film type ST504. The silver pattern on the substrate was washed with fresh methanol and distilled water, and dried with a nitrogen gun. The silver pattern on the substrate was sintered at 140°C for 48 hours.

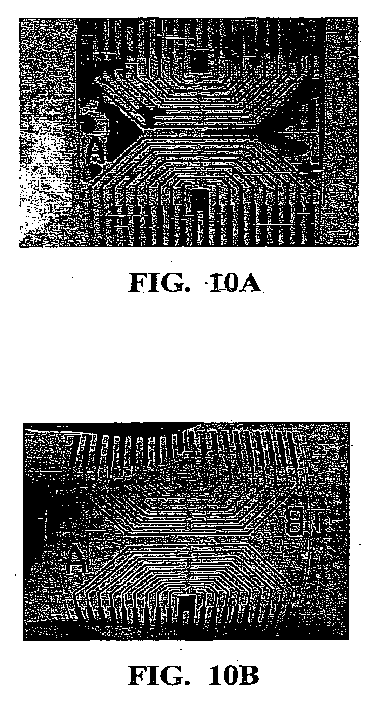

For both the Comparative Example and Example 2, images were taken of the pattern of source drain lines of the silver on the substrate and then compared. The image of the silver pattern produced by the Comparative Example is shown in Fig. 10a. The image of the silver pattern produced by Example 2 is shown in Fig. 10b. The silver pattern created by direct microcontact printing as described in Comparative Example showed functional silver material printed in open areas were there should be no functional material. In addition, the lines of the silver pattern were broken and particulate was observed on the substrate. In the large areas around the center and the large areas between the transistor pads silver was print deposited onto the substrate due to sagging of the recessed portions of the elastomeric stamp.

The printed pattern of silver included 20 electrodes in the top and bottom. The width of the electrodes was 0.5 mm and the separation between electrodes was also 0.5 mm. As observed in the image of Figure 10a, 16 out of the 21 spaces between electrodes had additional silver that transferred due to sagging of the stamp during printing. Triangular regions, located to the left and right of center bordered by diagonal lines of an outermost source and drain interdigitated lines and the letter A and the letter B, has an area of approximately 40 mm². Approximately 100 % of the triangular region on the left (by letter A) and about 70-80% of the triangular region on the right (by letter B) are covered with silver that transferred due to sagging of the stamp.

As observed in the image of Figure 10b, the pattern of silver made using the mask material layer as described in Example 2 show excellent conductive silver pattern formation, since all 21 spaces between electrodes clean and without any silver being transferred outside the patterning areas. In addition, the triangular regions as described above show no transfer of the silver. Comparison of the images show that, when printing conductors according to the method of the Comparative Example, sagging of the stamp causes undesired transfer of functional material which can clearly lead to shorting of various transistors lines, whereas the present method essentially eliminates the possibility of shorting in the lines. The present method avoids undesired transfer of functional material between and about feature lines and the formation of functional material in background areas.

## Claims

1. A method to form a pattern of a functional material on a substrate comprising:
a) providing an elastomeric stamp having a relief structure with a raised surface;
b) applying a mask material to at least the raised surface of the relief structure;
c) transferring the mask material from the raised surface to the substrate forming a pattern of open area on the substrate; and
d) applying the functional material to the open area on the substrate to form the pattern.

2. The method of Claim 1 further comprising after step d):
e) removing the mask material from the substrate.

3. The method of Claim 2 wherein the step e) comprises placing the substrate formed in step d) in a bath of a solvent for the mask material.

4. The method of Claim 3 further comprising applying sound waves to the bath.

5. The method of Claim 1 wherein the functional material is in solution, the method further comprising drying to form a film of the functional material on the substrate.

6. The method of Claim 1 wherein the functional material comprises nanoparticles.

7. The method of Claim 6 wherein the nanoparticles have a diameter of 3 to 100 nm.

8. The method of Claim 6 wherein the nanoparticles are selected from the group consisting of conductors, dielectrics, semiconductors, and combinations thereof.

9. The method of Claim 6 wherein the nanoparticles comprise a metal selected from the group consisting of silver, gold, copper, palladium, indium-tin oxide, and combinations thereof.

10. The method of Claim 6 wherein the nanoparticles are semiconducting nanoparticles selected from the group consisting of silicon, germanium, gallium arsenide, zinc oxide, zinc selenide, and combinations thereof.

11. The method of Claim 6 wherein the nanoparticles are quantum dots.

12. The method of Claim 6 wherein the nanoparticles are selected from the group consisting of carbon nanotubes, conducting carbon nanotubes, semiconducting carbon nanotubes, and combinations thereof.

13. The method of Claim 1 wherein the functional material comprises nanoparticles of metal in a liquid carrier, the method further comprising heating the nanoparticles on the substrate.

14. The method of Claim 1 wherein the step d) of applying the functional material is selected from the group consisting of injecting, pouring, liquid casting, jetting, immersion, spraying, vapor deposition, and coating.

15. The method of Claim 1 wherein the functional material is incompatible or substantially incompatible with the mask material.

## Patentansprüche

1. Verfahren zum Bilden eines Musters eines funktionellen Materials auf ein Substrat, umfassend:
a) Bereitstellen eines Elastomerstempels mit einer Reliefstruktur mit einer erhobenen Oberfläche;
b) Aufbringen eines Maskenmaterials auf mindestens die erhobene Oberfläche der Reliefstruktur;
c) Übertragen des Maskenmaterials von der erhobenen Oberfläche auf das Substrat, wobei ein Muster eines offenen Bereichs auf dem Substrat gebildet wird; und
d) Aufbringen des funktionellen Materials auf den offenen Bereich auf das Substrat, um das Muster zu bilden.

2. Verfahren nach Anspruch 1, feuer umfassend nach Schritt d):
e) Entfernen des Maskenmaterials vom Substrat.

3. Verfahren nach Anspruch 2, wobei Schritt e) das Tauchen des in Schritt d) gebildeten Substrats in ein Bad eines Lösungsmittels für das Maskenmaterial umfasst.

4. Verfahren nach Anspruch 3, ferner umfassend das Anwenden von Schallwellen auf das Bad.

5. Verfahren nach Anspruch 1, wobei das funktionelle Material in einer Lösung ist, wobei das Verfahren ferner das Trocknen umfasst, um einen Film des funktionellen Materials auf dem Substrat zu bilden.

6. Verfahren nach Anspruch 1, wobei das funktionelle Material Nanoteilchen umfasst.

7. Verfahren nach Anspruch 6, wobei die Nanoteilchen einen Durchmesseer von 3 bis 100 nm haben.

8. Verfahren nach Anspruch 6, wobei die Nanoteilchen aus der Gruppe ausgewählt sind bestehend aus Leitern, Dielektrika, Halbleitern, und Kombinationen davon.

9. Verfahren nach Anspruch 6, wobei die Nanoteilchen ein Metall umfassen, ausgewählt aus der Gruppe bestehend aus Silber, Gold, Kupfer, Palladium, Indiumzinnoxid, und Kombinationen davon.

10. Verfahren nach Anspruch 6, wobei die Nanoteilchen halbleitende Nanoteilchen sind, ausgewählt aus der Gruppe bestehend aus Silikon, Germanium, Gallium-Arsenid, Zinkoxid, Zinkselenid, und Kombinationen davon.

11. Verfahren nach Anspruch 6, wobei die Nanoteilchen Quantenpunkte sind.

12. Verfahren nach Anspruch 6, wobei die Nanoteilchen ausgewählt sind aus der Gruppe bestehend aus Kohlenstoffnanoröhren, leitenden Kohleristoffnanoröhren, halbleitenden Kohlenstoffnanoröhren, und Kombinationen davon.

13. Verfahren nach Anspruch 1, wobei das funktionelle Material Nanoteilchen aus Metall in einem flüssigen Träger umfasst, wobei das Verfahren ferner das Erhitzen der Nanoteilchen auf dem Substrat umfasst.

14. Verfahren nach Anspruch 1, wobei Schritt d) zum Aufbringen des Funktionellen Materials ausgewählt ist aus der Gruppe bestehend aus Einspritzen, Gießen, Flüssiggießen, Ausstoßen, Eintauchen, Aufsprühen, Dampfabscheidung, und Beschichtung.

15. Verfahren nach Anspruch 1, wobei das funktionelle Material mit dem Maskenmaterial unverträglich oder im Wesentlichen unverträglich ist.

## Revendications

1. Procédé pour former un motif d'un matériau fonctionnel sur un substrat, comprenant:
a) fournir un tampon élastomère ayant une structure en relief avec une surface surélevée;
b) appliquer un matériau de masque sur au moins la surface surélevée de la structure en relief;
c) transférer le matériau de masque de ladite surface surélevée au substrat, formant ainsi un motif de surface ouverte sur le substrat; et
d) appliquer le matériau fonctionnel sur l'aire ouverte sur le substrat pour former le motif.

2. Procédé selon la revendication 1, comprenant en outre après l'étape d):
e) retirer le matériau de masque du substrat.

3. Procédé selon la revendication 2, dans lequel l'étape e) comprend placer le substrat formé à l'étape d) dans un bain de solvant pour le matériau de masque.

4. Procédé selon la revendication 3, comprenant en outre l'application d'ondes sonores au bain.

5. Procédé selon la revendication 1, dans lequel le matériau fonctionnel est en solution, le procédé comprenant en outre le séchage pour former un film du matériau fonctionnel sur le substrat.

6. Procédé selon la revendication 1, dans lequel le matériau fonctionnel comprend des nanoparticules.

7. Procédé selon la revendication 6, dans lequel les nanoparticules ont un diamètre de 3 à 100 nm.

8. Procédé selon la revendication 6, dans lequel les nanoparticules sont sélectionnées dans le groupe constitué de conducteurs, de diélectriques, de semi-conducteurs, et de combinaisons de ceux-ci.

9. Procédé selon la revendication 6, dans lequel les nanoparticules comprennent un métal sélectionné dans le groupe constitué de l'argent, de l'or, du cuivre, du palladium, de l'oxyde d'indium-étain, et de combinaisons de ceux-ci.

10. Procédé selon la revendication 6, dans lequel les nanoparticules sont des nanoparticules semi-conductrices sélectionnées dans le groupe constitué du silicium, du germanium, de l'arsenure de gallium, de l'oxyde de zinc, du sélénure de zinc, et de combinaisons de ceux-ci.

11. Procédé selon la revendication 6, dans lequel les nanoparticules sont des nanocristaux fluorescents.

12. Procédé selon la revendication 6, dans lequel les nanoparticules sont sélectionnées dans le groupe constitué des nanotubes de carbone, des nanotubes de carbone conducteurs, des nanotubes de carbone semi-conducteurs, et de combinaisons de ceux-ci.

13. Procédé selon la revendication 1, dans lequel le matériau fonctionnel comprend des nanoparticules de métal dans un véhicule liquide, le procédé comprenant en outre le chauffage des nanoparticules sur le substrat.

14. Procédé selon la revendication 1, dans lequel l'étape d) consistant à appliquer le matériau fonctionnel est sélectionné dans le groupe constitué de l'injection, du coulage, de la fonte liquide, du jet, de l'immersion, de la pulvérisation, du dépôt en phase vapeur, et de l'enduisage.

15. Procédé selon la revendication 1, dans lequel le matériau fonctionnel est incompatible ou substantiellement incompatible avec le matériau de masque.
